(19) Europäisches Patentamt

European Patent Office

Office européen des brevets

(11) **EP 3 226 412 B1**

(12) **EUROPEAN PATENT SPECIFICATION**

(45) Date of publication and mention of the grant of the patent:
**27.10.2021 Bulletin 2021/43**

(51) Int Cl.:
*H03G 9/00* *(2006.01)*          *H03G 9/02* *(2006.01)*
*H04R 3/00* *(2006.01)*          *H04R 3/04* *(2006.01)*

(21) Application number: **17163745.7**

(22) Date of filing: **30.03.2017**

(54) **DYNAMIC SUPPRESSION OF NON-LINEAR DISTORTION**

DYNAMISCHE UNTERDRÜCKUNG VON NICHTLINEARER VERZERRUNG

SUPPRESSION DYNAMIQUE DE DISTORSION NON LINÉAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2016 EP 16162918**

(43) Date of publication of application:
**04.10.2017 Bulletin 2017/40**

(73) Proprietor: **Dolby Laboratories Licensing Corporation**
**San Francisco, CA 94103 (US)**

(72) Inventors:
• **GOESNAR, Erwin**
  **Sunnyvale, California 94085 (US)**
• **GUNAWAN, David**
  **McMahons Point, NSW NSW 2060 (AU)**

(74) Representative: **Dolby International AB**
**Patent Group Europe**
**Apollo Building, 3E**
**Herikerbergweg 1-35**
**1101 CN Amsterdam Zuidoost (NL)**

(56) References cited:
**EP-A1- 2 600 636**      **US-A1- 2008 152 168**
**US-A1- 2012 106 750**      **US-A1- 2013 142 360**

**Description**

TECHNICAL FIELD

Embodiments herein relate generally to audio signal processing, and more specifically to dynamic suppression of non-linear distortion based on loudness.

SUMMARY OF THE INVENTION

The invention is defined in the independent claims. Favourable realisations of the invention are defined in the dependent claims.

PRIOR ART

US 2013/142360 A1 discloses a method and system for controlling distortion of the output of a miniature speaker by attenuating critical frequency band of the input signal to be reproduced, using tuning parameters that have been predetermined where the critical frequency band is a frequency range of the speaker's frequency response in which Total Harmonic Distortion (THD) peaks.

EP 2 600 636 A1 discloses a method and a device for reducing distortion from an associated loudspeaker acoustically mounted such that it exhibits a lower resonance frequency Fc. A limited frequency band, including Fc, of an audio input signal is attenuated. In particular EP 2 600 636 A1 discloses a system for providing dynamic suppression of distortion in an audio signal, the system comprising a notch filter configured to receive an input audio signal and to output a notch-filtered audio signal, a peak filter configured to receive the input audio signal and to output a peak-filtered audio signal, wherein the peak filter has the same center frequency as the notch filter; means for computing signal-energy values for the peak-filtered audio signal, a limiter configured to limit the peak-filtered audio signal according to a target output level, thereby generating a limited audio signal; means for combining the notch filtered audio signal and the limited audio signal, thereby generating a combined audio signal; and an output for outputting the combined audio signal. EP 2 600 636 A1 also discloses a corresponding method and a computer executable program code arranged to perform the method.

BRIEF DESCRIPTION OF THE FIGURES

This disclosure is illustrated by way of example and not limitation in the figures of the accompanying drawings, in which like references indicate similar elements, and in which:

FIG. 1 shows a flow diagram for a method providing dynamic suppression of non-linear distortion for a device, according to an embodiment which is not part of the invention.

FIG. 2 shows a simplified block diagram of a system providing dynamic suppression of non-linear distortion for a device, according to an embodiment which is not part of the invention.

FIG. 3 shows a simplified block diagram of a dynamic shelf filter, according to an embodiment which is not par of the invention.

FIG. 4 shows a flow diagram for a method providing dynamic suppression of non-linear distortion for a device by a multi-band limiter, according to an embodiment which is not part of the invention.

FIG. 5 shows a simplified block diagram of a multi-band limiter that provides dynamic suppression of non-linear distortion for a device, according to an embodiment which is in accordance with the invention.

FIG. 6 shows a flow diagram for a method for setting limiter targets within a multi-band limiter, according to an embodiment which is not part of the invention.

FIG. 7 shows a simplified block diagram illustrating setting of limiter targets within a multi-band limiter, according to an embodiment which is not part of the invention.

FIGS. 8A-8B show plots describing a mapping function of a multi-band limiter that provides dynamic suppression of non-linear distortion for a device and the resulting suppression provided by the multi-band limiter respectively.

FIG. 9 shows a simplified block diagram of a multi-band limiter that provides dynamic suppression of non-linear distortion for a device according to an embodiment which is in accordance with the invention. device.

FIGS. 10A-10B show plots describing levels of harmonic distortion for a device at -15 and -9 DB.

FIGS. 11A-11B show plots describing levels of harmonic distortion for a device at -15 and -9 DB using a system for dynamic suppression of non-linear distortion for the device.

FIG. 12 is a block diagram of an exemplary system for providing dynamic suppression of non-linear distortion for a device, according to an embodiment which is not part of the invention.

DETAILED DESCRIPTION

The audio quality of certain audio devices, such as speakerphones, typically degrades as the speaker volume increases. At loud volume level, overtone or even buzzing may be heard on the receive end of the device. In the addition, for a duplex system, the far end might either hear occasional echo leakage or hear heavily suppressed voice of near end talker when the non-linear distortion of the speaker is high depending on the setting of the echo suppressor.

To reduce the distortion, conventional solutions apply notch filters or limiters to suppress the audio at the resonant frequencies of the system where the distortions are high. However, these techniques have shortcomings. Notch filters also suppress the audio at lower loudness levels, where the non-linear distortion is low. Suppressing the audio at lower loudness levels may degrade the audio quality when such suppression is unnecessary. Conversely, the amount of suppression of a limiter can be very aggressive for loud signals. Unduly aggressive suppression caused by a limiter may unnecessarily degrade the audio quality if significant limiting is used to suppress problematic frequencies for a signal with mid-level loudness.

The proposed solution described herein preserves audio quality by analyzing playback signals to dynamically shape, attenuate or limit the spectrum of the loudspeaker signals of the device in accordance with the amount of non-linear distortion present. Accordingly, the described solution preserves the timbre and reduces non-linear distortion of the device, without unduly suppressing the underlying audio signal being played on the loudspeaker.

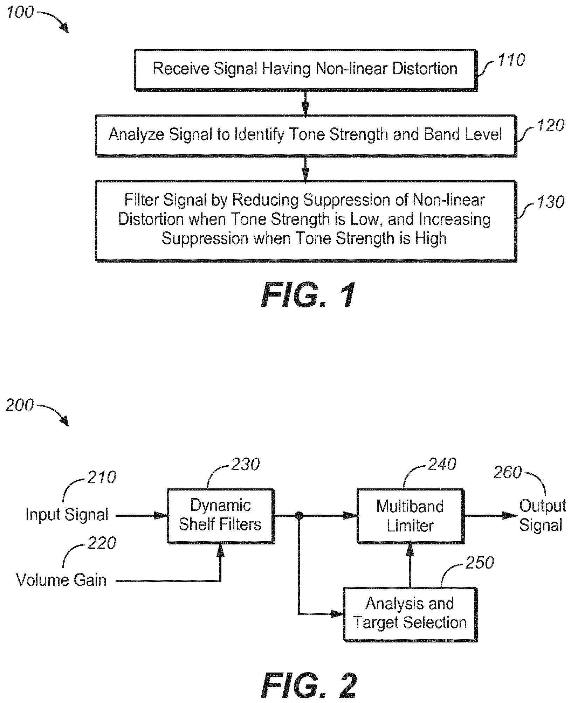

FIG. 1 shows a flow diagram for method 100 providing dynamic suppression of non-linear distortion for a device, under an embodiment. Using method 100, the speaker output signal of an audio device (such as a speakerphone) is controlled to reduce the non-linear distortion for improving duplex performance and consistent timbre may be provided at various device volume levels. FIG. 2 shows a simplified block diagram of a volume modeling system 200 providing dynamic suppression of non-linear distortion for a device, according to an embodiment, using the method 100 described in FIG. 1. The exemplary volume modeling system 200 includes dynamic shelf filters 230, multi-band limiter circuit 240 and analysis and target selection circuit 250. The multi-band limiter 240, as is described in further detail below, may be designed to prevent or reduce the occurrences of non-linear distortion on the captured signal during audio playback.

In method 100, a signal may be received on a device at step 110, the device having non-linear distortion effects at a pre-determined frequency. The signal may be any suitable audio signal, and the device may be any audio device having a speaker, such as a mobile telephonic device having a speaker phone function, or a dedicated speaker phone. The device may include the exemplary volume modeling system 200, for example. While not required in all embodiments, dynamic shelf filters 230 may be designed to preserve the timbre as the volume level changes.

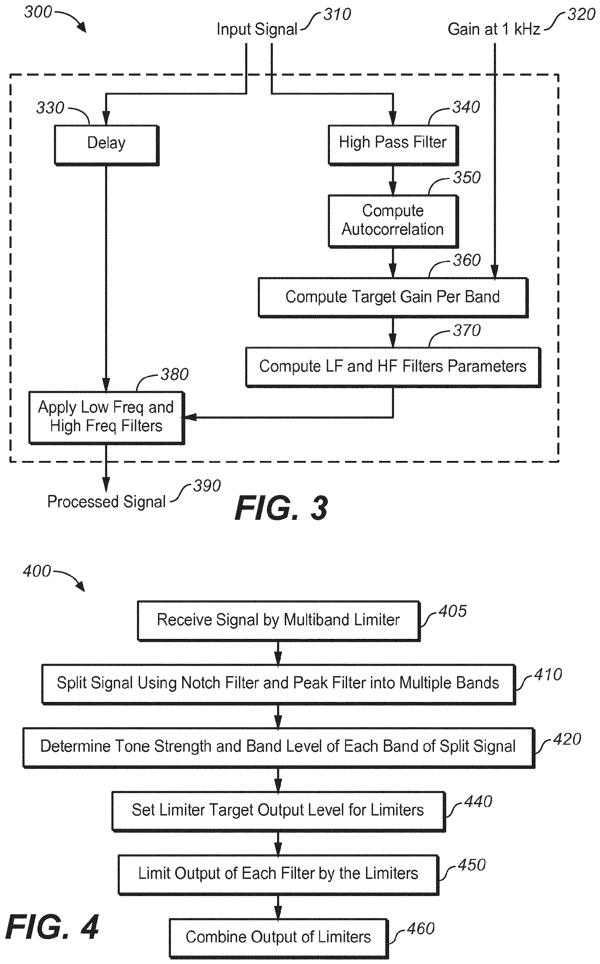

FIG. 3 shows a simplified block diagram of a dynamic shelf filters 300, according to an embodiment. The received input signal 310 and a desired volume gain level (shown at the predetermined frequency of 1 kHz in FIG. 3; however the desired volume gain may be set at any desired predetermined frequency) may be received as inputs to the dynamic shelf filter 300. The input signal may have a loudness parameter corresponding to a loudness level of the received audio signal 310. The desired gain may be equal to a desired loudness change of the loudness parameter, and may be set by a user, for example. The received signal 310 may be processed by passing through a high pass filter 340. An autocorrelation is computed at analysis block 350 The autocorrelation may be used to measure the power spectral density of the input signal around the anchor bands, and analysis block 350 may output band levels for each of the bands of the input signal. Based on the loudness parameter of the input signal 310, the volume gain 320, and the computed band levels from autocorrelation 350, a target gain per band may be computed at block 360 and filter parameters may be computed at block 370 In a signal path of dynamic shelf filters 300, the signal may be delayed at block 330 while the processing steps are taking place. In response to the filter parameters being computed, low and high shelf filters may be applied at block 380 to the output signals to preserve the timbre. A the loudness parameter of the input signal 310 increases, the dynamic filters 380 may attenuate the low frequency and the high frequency bands. On the other hand, when the loudness parameter decreases, the filters 380 may boost the low frequency and high frequency bands. Note that this processing was originally designed to preserve timbre for audio playback device but this also helps in controlling echo at higher volume when reducing the low frequency to preserve timbre. The output of the dynamic shelf filters 390 may be the signal received by the multi-band limiter 240.

Returning to FIG. 1, the received signal may be analyzed to identify a tone strength parameter and a band level of the received signal at step 120. Step 120 may be handled by the analysis and target selection circuit 250, which may be external to multi-band limiter 240 (as shown in FIG. 2) or may be internal to the multi-band limiter 240 in some embodiments. The multi-band limiter 240 may then filter the received signal such that the spectrum of the input signal is dynamically limited at step 130. That is, suppression of the non-linear distortion may be reduced by the multi-band limiter 240 when the tone strength parameter is in a lower portion of a predetermined range and suppression of the non-linear distortion may be increased when the tone strength parameter is in an upper portion of the predetermined range. The predetermined range of the tone strength parameter may correspond to a loudness range of the device, where the lower portion corresponds to a lower volume audio signal and the upper portion corresponds to a higher volume signal.

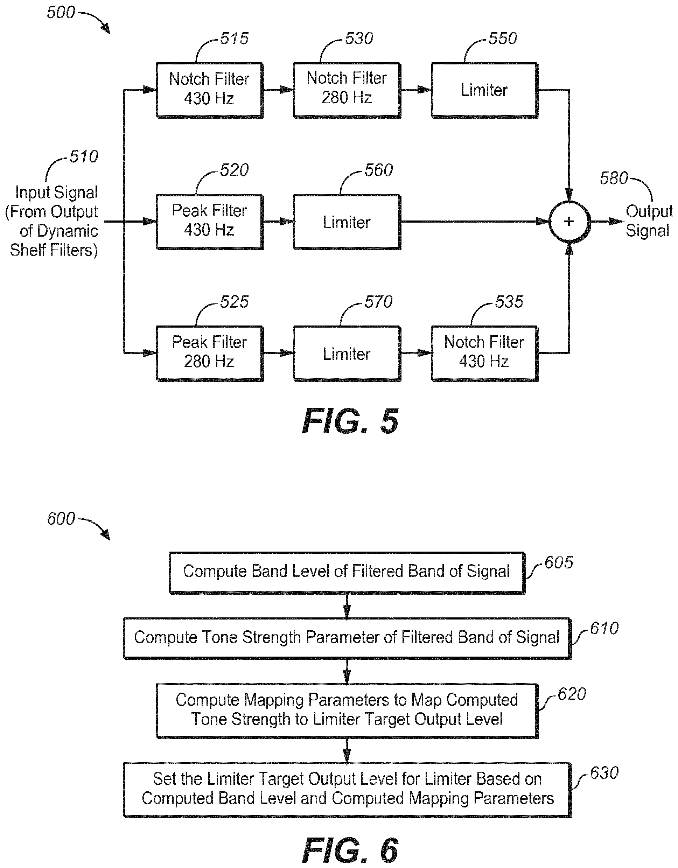

FIG. 4 shows a flow diagram for a method 400 of providing dynamic suppression of non-linear distortion for a device by a multi-band limiter, according to an embodiment. FIG. 4 provides a more detailed description of an embodiment of the multi-band limiter 240 described above. FIG. 5 shows a simplified block diagram of a multi-band limiter 500 that provides dynamic suppression of non-linear distortion for a device, according to an embodiment. While the multi-band limiter may only filter on one predetermined frequency, the multi-band limiter 500 filters on two predetermined frequencies, 430 Hz and 280 Hz, using two pairs of notch filters and peak filters. The first notch-peak pair (515 and 520 respectively) filter at 430 Hz, while the second notch-peak pair (530 and 525 respectively) filter at 280 Hz. Multi-band limiter 500 also includes three limiters 550, 560, and 570.

According to method 400, a signal 510 is received by the multi-band limiter. As shown in FIG. 5, the signal may be the output of dynamic shelf filters, such as dynamic shelf filters 300. The received signal is split, by the multi-band limiter 500, into a plurality of bands using a notch filter and a peak filter at step 410 (e.g., notch filter 515 and peak filter 520). Each filter has a center frequency tuned to a predetermined frequency for the device, where each filter filters one of the plurality of bands. In an embodiment, the notch and peak filters are bi-quad filters. While a single center frequency may be used for the multi-band limiter, multi-band limiter 500 utilizes two center frequencies, 430 Hz and 280 Hz. Furthermore, in multi-band limiter 500, the splitting of the received signal is done by splitting the received signal into three bands using two notch filters 515 and 530 (connected in series) paired with two peak filters 520 and 525. In an embodiment, the response of the sum of peak and notch filters for a given predetermined frequency may equal one (meaning perfect reconstruction of the received input signal 510). The center frequencies of the notch or peak filters may be tuned to the frequencies which need limiting. An exemplary process of identifying which frequencies to limit is described below.

Each notch filter and peak filter pair is set to a predetermined frequency, where both notch filters 515 and 530 filter a single band, and each peak filter 520 and 525 filters a separate band. The notch filters 515 and 530 each remove a component from the received signal that may trigger non-linear distortion, and output bands of the signal without the components that may trigger non-linear distortion. Conversely, the peak filters 520 and 525 extract the peaks of the input signal that include the components from the received signal that may trigger non-linear distortion. The peak filters 520 and 525 accordingly output only the components of the received signal that may trigger non-linear distortion.

Multi-band limiter 500 includes three limiters 550, 560, and 570, each limiter limiting a separate band. In an embodiment which is not in accordance with the invention, limiter 550 may apply light filtering to the band received from the output of notch filter 530 by having a target output level set to a constant value, such as a headroom of the device (e.g., -3 dbFS). In an embodiment in accordance with the invention, the limiter targets of limiters 560 and 570 are dynamic and are set based on the tone strength of the band received by limiters 560 and 570 respectively from the peak filters. By controlling the limiter targets of limiters 560 and 570, the amount of suppression of the distortion component is dynamically adjusted, and the adjustment of the amount of suppression may be done with minimal latency. The computation of the limiter targets of limiters 560 and 570 is discussed in further detail below.

As shown in FIG. 5, the output of limiter 570, which limits the output of peak filter 525, may also be filtered by optional notch filter 535 at 430 Hz. Notch filter 535 may be the same filter as notch filter 515 or may be separately implemented. Notch filter 535 advantageously filters the peak at 280 Hz of the received signal, allowing more precise limiting around the 280 Hz non-linear distortion peak without affecting the higher frequencies of the received signal. If the quality factor (Q factor) of the notch and peak filters are high and the center frequencies being filtered have a relatively large difference, then the amount of leakage between the bands may be relatively small. In such a scenario, notch filter 535 may not make a significant difference in the limiting, and may therefore be omitted.

The coefficients of the notch and peak filters may be computed in an exemplary embodiment using the code shown below. Using the bi-quad filters described below may advantageously reduce processing overhead in performing the filtering of the received bands.

$$\text{function } [b,a] = \text{biquadNotch}(w0,bw0)$$

% Design biquad notch filter

$$bw0 = bw0*pi;$$

$$w0 = w0*pi;$$

$$beta = \tan(bw0/2);$$

$$gain = 1/(1+beta);$$

$$b = gain*[1 \ -2*\cos(w0) \ 1];$$

$$a = [1 \ -2*gain*\cos(w0) \ (2*gain-1)];$$

end

function [b,a] = biquadPeak(w0,bw0)

% Design biquad peak filter

$$bw0 = bw0*pi;$$

$$w0 = w0*pi;$$

$$beta = tan(bw0/2);$$

$$gain = 1/(1+beta);$$

$$b = (1-gain)*[1\ 0\ -1];$$

$$a = [1\ -2*gain*cos(w0)\ (2*gain-1)];$$

end

While biquad filters are described above, other filter definitions may be used to define a filtering scheme prior to applying the limiters of the multiband limiter. For example, another approach would be to use a filter bank to split the received signal into multiple bands in the frequency domain. Using a filter bank may be disadvantageous to the biquad notch and peak filters described above, however, since the filter bank may have higher complexity and higher delay.

Returning to FIG. 4, both a tone strength parameter and a band level of each filtered band of the split received signal are computed at step 420. This may be done, for example, by measuring the energies of the peak and notch filter output signals. The tone strength parameter may be defined as a ratio of the energies of the peak and notch filter output signals (e.g., peak filter output signal energy divided by notch filter output signal energy for filters at the same center frequency), and the band level may be equal to the energy of the peak filter output signal. Using the computed tone strength parameter and band level for each band, limiter target output levels for the plurality of limiters may be set at step 440. As shown in FIG. 5, each limiter 550, 560, and 570 receives a filtered band of the received signal from a filter. Each limiter target output level may be set such that suppression of the non-linear distortion is reduced when the tone strength parameter is in a lower portion of a predetermined range and suppression of the non-linear distortion is increased when the tone strength parameter is in an upper portion of the predetermined range. The predetermined range of the tone strength parameter may correspond to a loudness range of the device. When the tone strength is low, the amount of signal outside of the problematic frequency may be fairly strong. The distortion is most likely masked by the clean signal so the user would not hear much of the distortion on the playback, making it desirable to have less suppression of the non-linear distortion. Moreover, since there is strong energy on the reference signal outside the problematic frequency, an echo suppressor can typically suppress the non-linear echo. Hence the amount of suppression can be reduced as the tone strength decreases.

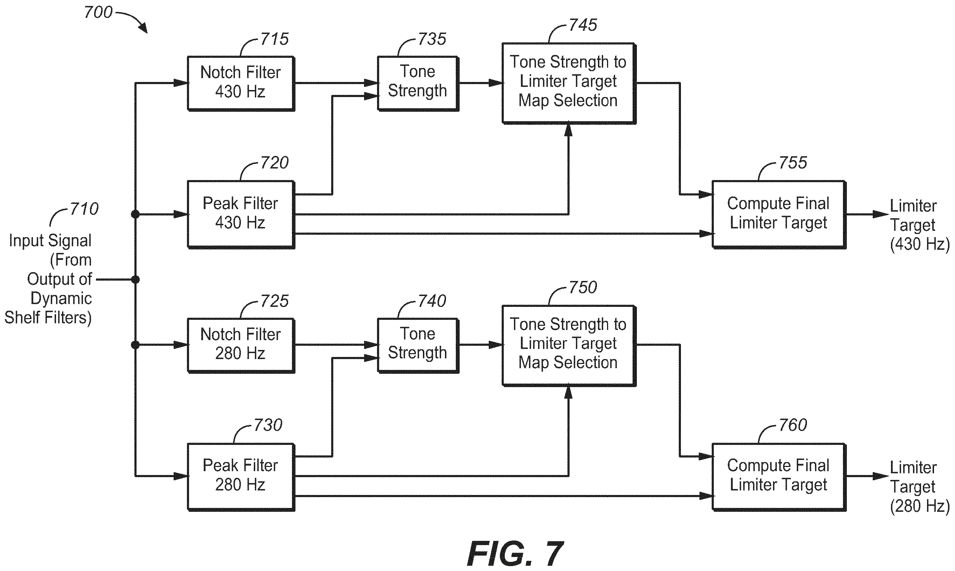

The targets of the limiters around the notch frequencies dependof the tonal strength of the input signal as well as the band levels around the notch center frequencies. FIG. 6 shows a flow diagram for a method 600 for setting limiter targets within a multi-band limiter, according to an embodiment. FIG. 7 shows a simplified block diagram 700 illustrating setting of limiter targets within a multi-band limiter, according to an embodiment. The setting of limiter targets may be performed by, for example, the analysis circuit 250 of FIG. 2.

First, the band levels, which may be defined as the energies of the output of the peak filters 720 and 730 at a given center frequency (e.g., 430 Hz and 280 Hz respectively), may be computed for each band at step 605. The tone strength parameters, where the tone strength may be defined as the ratio of the energies of the peak and notch filter outputs at a given center frequency, may be computed at step 610. In FIG. 7, this is displayed by block 735 for the center frequency 430 Hz and block 740 for the center frequency 280 Hz. Based on the computed band levels and the computed tone strength parameters, the parameters for mapping the tone strength to limiter target output level may be computed at step 620.

The mapping function for the limiter target output levels may be computed in block 745 for the 430 Hz center frequency and block 750 for the 280 Hz center frequency. The mapping function for the limiter target output level of each limiter may be determined by measuring the distortion of the device to estimate the amount of suppression needed to reduce the distortion. The input parameters to the mapping function may be the computed tone strength parameter and the band level of the band at the center frequency being filtered. For the example in FIG. 7, since there are two frequencies being targeted for suppression, there may be two independent corresponding mapping functions computed. The mapping functions may be selected such that, as the band level for a band increases, the mapping function will be more aggressive (i.e. a smaller value of the tone strength parameter is needed to produce larger limiter output target level) to create limiting on wider frequencies. This may be done, for example, by selecting mapping parameters that vary in direct proportion to the computed band level of the filtered band.

The limiter target output level for each limiter may be set based on the computed band level and the computed mapping parameters at step 630. This is done in block 755 for the 430 Hz center frequency and block 760 for the 280 Hz center frequency. In an embodiment, the mapping function may set the limiter output target level to equal "— bandLevel+headroom+depth" in decibels. That is, the limiter target output level for each limiter being equal to a sum of the negation of the computed band level of the filtered band, a predetermined headroom value, and a depth parameter, the depth parameter falling within a predetermined range and being related to the computed band level of the filtered band. The depth parameter may depend on the band level of the filtered band of the signal received by the limiter, which may vary in a predetermined range from minDepth to maxDepth. For high band level filtered bands (e.g., >= -3 decibels relative to full scale [DBFS]) and low band level filtered bands (e.g., <= -9 dBFS), the depths parameters may be set to maxDepth and minDepth respectively. For other band levels of the filtered band (e.g., a band level between - 9 dBFS and -3 dBFS), the depth parameter may be set linearly between maxDepth and minDepth in an exemplary embodiment. The headroom may be a constant value, such as 3 dB, for example.

Returning to FIG. 4, the multi-band limiter may limit the output of each filter by each of the limiters based on the set limiter target output levels at step 450. Signals below the set limiter target output level may be allowed to pass, while signals above the set limiter target output level may accordingly be attenuated. At step 460, the outputs of each of the limiters may be combined, thereby providing a processed signal as an output of the multi-band limiter.

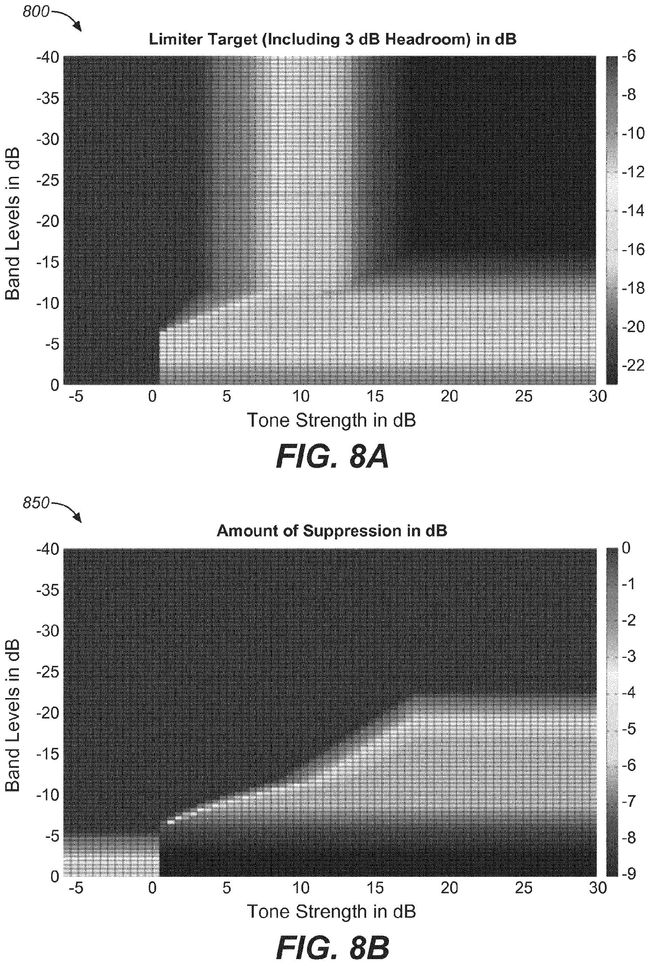

FIGS. 8A-8B show plots describing a mapping function of a multi-band limiter of set points that provides dynamic suppression of non-linear distortion for a device and the resulting suppression provided by the multi-band limiter respectively. The set points are the limiter target values derived via the mapping function. Plot 800 illustrates an example of the operation of a mapping function based on the embodiment described above, with a headroom of 3 dB. The input of the mapping function displayed in plot 800 may be the band level and the tone strength parameter of the received band, as described above. Plot 800 illustrates that at low tone strengths, the mapping function causes the limiter target to be set to the lower end of the spectrum to the right of plot 800 (i.e., -6 to -10 dB). However, as the tone strength increases (corresponding to an increase in loudness), suppression becomes increasingly aggressive. This is shown in the top right area of plot 100, where the tone strength is above 15 dB. In this upper region of the tone strength range, the limiter target is set to the higher end of the spectrum, approximately 20-22 dB. Plot 850 displays the resulting suppression at a center frequency being filtered, for given values of the band level and the tone strength parameter of the band of the input signal received by a limiter of the multi-band limiter. As plot 850 illustrates, the suppression provided by the limiter increases as tone strength and/or band level increases for the received band of the input signal.

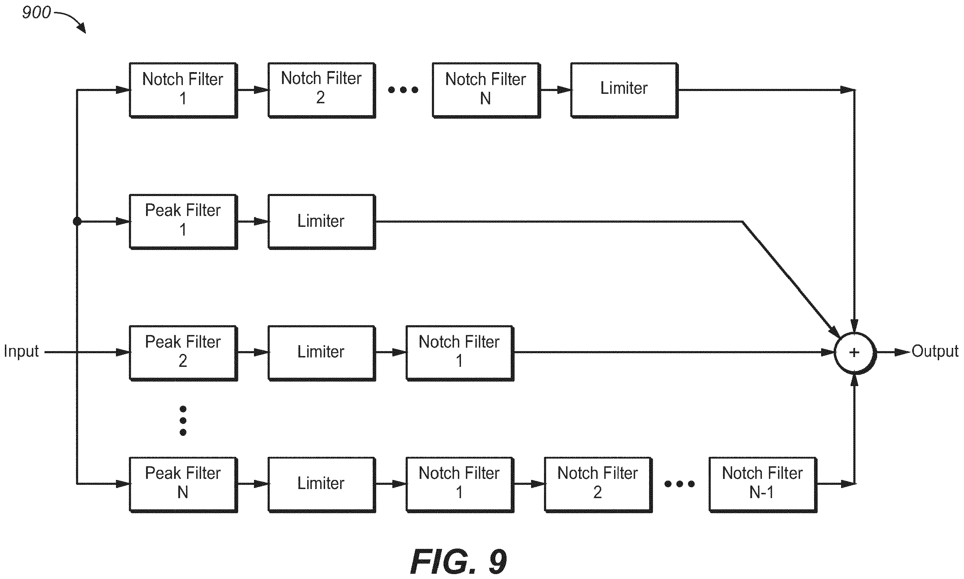

While the exemplary multi-band limiters shown in FIGS. 4-7 are for two center frequencies, the present invention is not limited in this regard and may have as many center frequencies as desired. FIG. 9 shows a simplified block diagram of an exemplary multi-band limiter 900 that provides dynamic suppression of non-linear distortion for a device, the multi-band limiter 900 having an arbitrary number of bands N. As multi-band limiter 900 shows, the splitting the received signal includes splitting the received signal into a plurality of bands using N notch filters paired with N peak filters, wherein N is greater than two. Each notch filter and peak filter pair is set to a predetermined center frequency. In multi-band limiter 900, the N notch filters filter a single band, and each peak filter filters a separate band of the received signal. The multi-band limiter 900 also includes N limiters, each limiter limiting a separate band received from a peak filter in the manner described above with reference to figure 5 (e.g., using a computed target output value derived using a mapping function).

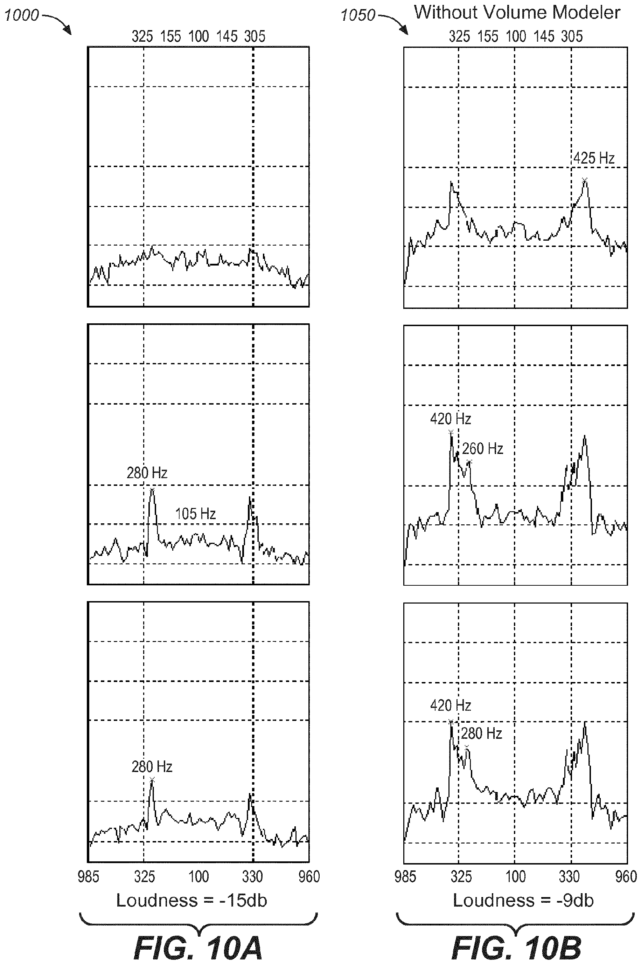

To find problematic frequencies for a particular device to dynamically suppress the non-linear distortion in incoming and outgoing signals from the device, many suitable methods may be used. One such method may be to play swept tones from a predetermined frequency range (e.g., 100 Hz to 1 kHz) at different tone strengths (e.g., from -3 dBFS to -18 dBFS) on the device, and record the output signal. The levels of the harmonic distortion of the captured output signal may be recorded for each played swept tone. One or more frequencies within the predetermined frequency range may be identified where recorded levels of harmonic distortion have a peak. FIGS. 10A-10B show plots 1000 and 1050 describing levels of harmonic distortion for a device at -15 dB and -9 dB respectively. At -15 dB, peaks of harmonic distortion may be observed at 280 Hz and 105 Hz in plot 1000. Likewise, at -9 dB, the plots indicate peaks at 425 Hz, 420 Hz, and 260 Hz.

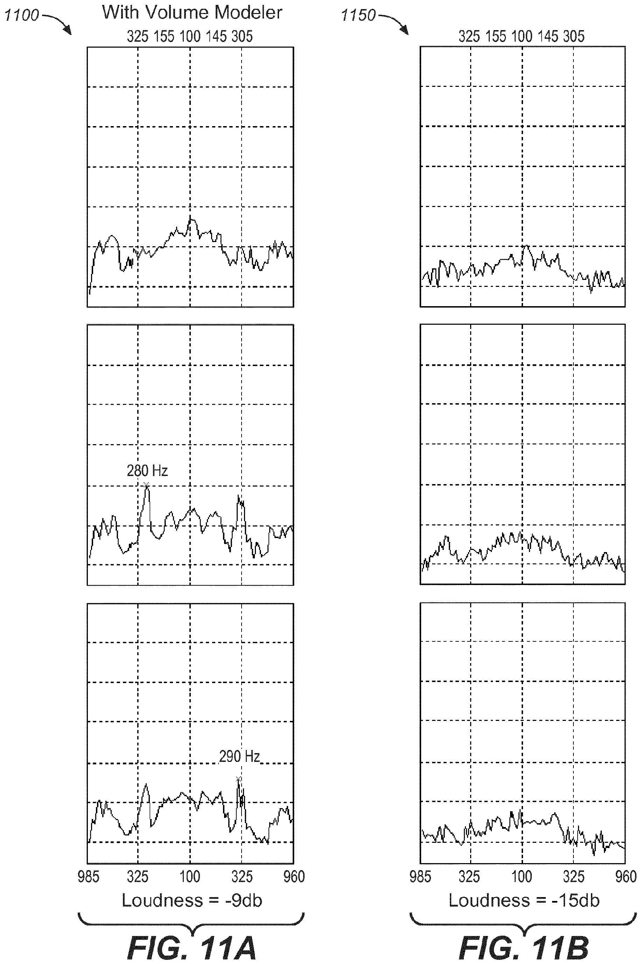

Once peak frequencies for a device are identified, the center frequencies of the notch and peak filters may be tuned to these identified dominant peak frequencies in an embodiment. FIGS. 11A-11B show plots 1100 and 1150 describing levels of harmonic distortion for a device (i.e., the same device as used for plots 1000 and 1050) at -15 and -9 DB respectively using a system for dynamic suppression of non-linear distortion for the device, such as volume modeling system 200. Plot 1100 shows reduced harmonic distortion, although a peak is still visible at 280 Hz. Since the loudness (i.e. tone strength) is less in plot 1100 compared to plot 1150, less aggressive suppression may be used. By contrast, plot 1150 does not show any peaks; the greater tone strength leads to more aggressive suppression of non-linear distortion.

Other methods may be used to select the notch and peak filter center frequencies. For example, the notch and peak filter center frequencies (and depths, in some embodiments) may be chosen based on the average distortion characteristic of a population of devices (e.g. 10, 20, or 100 devices). For example, the predetermined frequency for the multi-band limiter may be set at a frequency wherein harmonic distortion is greatest on average for a plurality of devices.

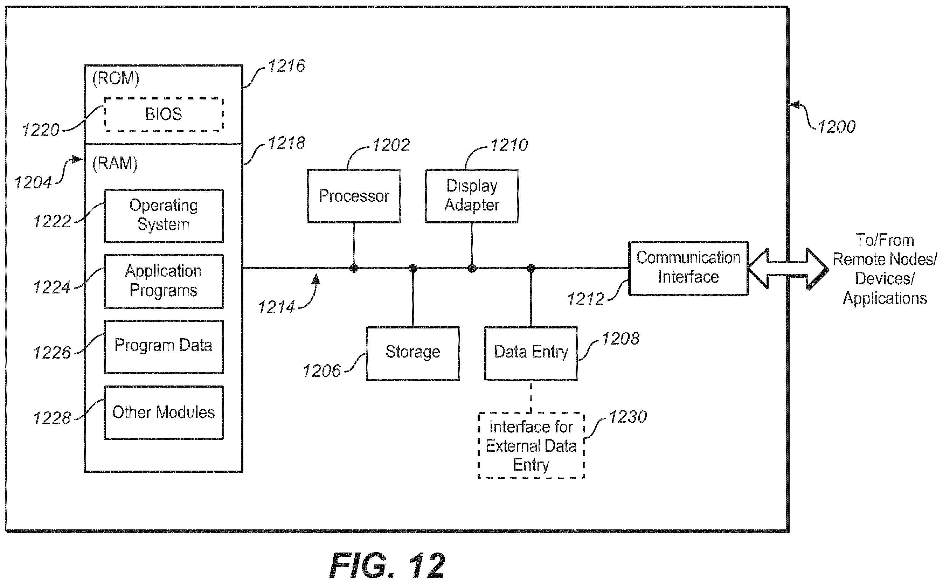

FIG. 12 is a block diagram of an exemplary system for providing dynamic suppression of non-linear distortion for a device. With reference to FIG. 12, an exemplary system for implementing the subject matter disclosed herein, including the methods described above, includes a hardware device 1200, including a processing unit 1202, memory 1204, storage 1206, data entry module 1208, display adapter 1210, communication interface 1212, and a bus 1214 that couples elements 1204-1212 to the processing unit 1202.

The bus 1214 may comprise any type of bus architecture. Examples include a memory bus, a peripheral bus, a local bus, etc. The processing unit 1202 is an instruction execution machine, apparatus, or device and may comprise a microprocessor, a digital signal processor, a graphics processing unit, an application specific integrated circuit (ASIC), a field programmable gate array (FPGA), etc. The processing unit 1202 may be configured to execute program instructions stored in memory 1204 and/or storage 1206 and/or received via data entry module 1208.

The memory 1204 may include read only memory (ROM) 1216 and random access memory (RAM) 1218. Memory 1204 may be configured to store program instructions and data during operation of device 1200. In various embodiments, memory 1204 may include any of a variety of memory technologies such as static random access memory (SRAM) or dynamic RAM (DRAM), including variants such as dual data rate synchronous DRAM (DDR SDRAM), error correcting code synchronous DRAM (ECC SDRAM), or RAMBUS DRAM (RDRAM), for example. Memory 1204 may also include nonvolatile memory technologies such as nonvolatile flash RAM (NVRAM) or ROM. In some embodiments, it is contemplated that memory 1204 may include a combination of technologies such as the foregoing, as well as other technologies not specifically mentioned. When the subject matter is implemented in a computer system, a basic input/output system (BIOS) 1220, containing the basic routines that help to transfer information between elements within the computer system, such as during start-up, is stored in ROM 1216.

The storage 1206 may include a flash memory data storage device for reading from and writing to flash memory, a hard disk drive for reading from and writing to a hard disk, a magnetic disk drive for reading from or writing to a removable magnetic disk, and/or an optical disk drive for reading from or writing to a removable optical disk such as a CD ROM, DVD or other optical media. The drives and their associated computer-readable media provide nonvolatile storage of computer readable instructions, data structures, program modules and other data for the hardware device 1200.

It is noted that the methods described herein can be embodied in executable instructions stored in a non-transitory computer readable medium for use by or in connection with an instruction execution machine, apparatus, or device, such as a computer-based or processor-containing machine, apparatus, or device. It will be appreciated by those skilled in the art that for some embodiments, other types of computer readable media may be used which can store data that is accessible by a computer, such as magnetic cassettes, flash memory cards, digital video disks, Bernoulli cartridges, RAM, ROM, and the like may also be used in the exemplary operating environment. As used here, a "computer-readable medium" can include one or more of any suitable media for storing the executable instructions of a computer program in one or more of an electronic, magnetic, optical, and electromagnetic format, such that the instruction execution machine, system, apparatus, or device can read (or fetch) the instructions from the computer readable medium and execute the instructions for carrying out the described methods. A non-exhaustive list of conventional exemplary computer readable medium includes: a portable computer diskette; a RAM; a ROM; an erasable programmable read only memory (EPROM or flash memory); optical storage devices, including a portable compact disc (CD), a portable digital video disc (DVD), a high definition DVD (HD-DVD™), a BLU-RAY disc; and the like.

A number of program modules may be stored on the storage 1206, ROM 1216 or RAM 1218, including an operating system 1222, one or more applications programs 1224, program data 1226, and other program modules 1228. A user may enter commands and information into the hardware device 1200 through data entry module 1208. Data entry module 1208 may include mechanisms such as a keyboard, a touch screen, a pointing device, etc. Other external input devices (not shown) are connected to the hardware device 1200 via external data entry interface 1230. By way of example and not limitation, external input devices may include a microphone, joystick, game pad, satellite dish, scanner, or the like. In some embodiments, external input devices may include video or audio input devices such as a video camera, a still camera, etc. Data entry module 1208 may be configured to receive input from one or more users of device 1200 and to deliver such input to processing unit 1202 and/or memory 1204 via bus 1214.

The hardware device 1200 may operate in a networked environment using logical connections to one or more remote nodes (not shown) via communication interface 1212. The remote node may be another computer, a server, a router, a peer device or other common network node, and typically includes many or all of the elements described above relative to the hardware device 1200. The communication interface 1212 may interface with a wireless network and/or a wired network. Examples of wireless networks include, for example, a BLUETOOTH network, a wireless personal area network, a wireless 802.11 local area network (LAN), and/or wireless telephony network (e.g., a cellular, PCS, or GSM network). Examples of wired networks include, for example, a LAN, a fiber optic network, a wired personal area network, a telephony network, and/or a wide area network (WAN). Such networking environments are commonplace in intranets, the Internet, offices, enterprise-wide computer networks and the like. In some embodiments, communication interface 1212 may include logic configured to support direct memory access (DMA) transfers between memory 1204 and other devices.

In a networked environment, program modules depicted relative to the hardware device 1200, or portions thereof, may be stored in a remote storage device, such as, for example, on a server. It will be appreciated that other hardware and/or software to establish a communications link between the hardware device 1200 and other devices may be used.

It should be understood that the arrangement of hardware device 1200 illustrated in FIG. 12 is but one possible implementation and that other arrangements are possible. It should also be understood that the various system components (and means) defined by the claims, described above, and illustrated in the various block diagrams represent logical components that are configured to perform the functionality described herein. For example, one or more of these system components (and means) can be realized, in whole or in part, by at least some of the components illustrated in the arrangement of hardware device 1200. In addition, while at least one of these components are implemented at least partially as an electronic hardware component, and therefore constitutes a machine, the other components may be implemented in software, hardware, or a combination of software and hardware. More particularly, at least one component defined by the claims is implemented at least partially as an electronic hardware component, such as an instruction execution machine (e.g., a processor-based or processor-containing machine) and/or as specialized circuits or circuitry (e.g., discrete logic gates interconnected to perform a specialized function), such as those illustrated in FIG. 12. Other components may be implemented in software, hardware, or a combination of software and hardware. Moreover, some or all of these other components may be combined, some may be omitted altogether, and additional components can be added while still achieving the functionality described herein. Thus, the subject matter described herein can be embodied in many different variations.

In the description above, the subject matter may be described with reference to acts and symbolic representations of operations that are performed by one or more devices, unless indicated otherwise. As such, it will be understood that such acts and operations, which are at times referred to as being computer-executed, include the manipulation by the processing unit of data in a structured form. This manipulation transforms the data or maintains it at locations in the memory system of the computer, which reconfigures or otherwise alters the operation of the device in a manner well understood by those skilled in the art. The data structures where data is maintained are physical locations of the memory that have particular properties defined by the format of the data. However, while the subject matter is being described in the foregoing context, it is not meant to be limiting as those of skill in the art will appreciate that various of the acts and operation described hereinafter may also be implemented in hardware.

For purposes of the present description, the terms "component," "module," and "process," may be used interchangeably to refer to a processing unit that performs a particular function and that may be implemented through computer program code (software), digital or analog circuitry, computer firmware, or any combination thereof.

It should be noted that the various functions disclosed herein may be described using any number of combinations of hardware, firmware, and/or as data and/or instructions embodied in various machine-readable or computer-readable media, in terms of their behavioral, register transfer, logic component, and/or other characteristics. Computer-readable media in which such formatted data and/or instructions may be embodied include, but are not limited to, physical (non-transitory), non-volatile storage media in various forms, such as optical, magnetic or semiconductor storage media.

Unless the context clearly requires otherwise, throughout the description and the claims, the words "comprise," "comprising," and the like are to be construed in an inclusive sense as opposed to an exclusive or exhaustive sense; that is to say, in a sense of "including, but not limited to." Additionally, the words "herein," "hereunder," "above," "below," and words of similar import refer to this application as a whole and not to any particular portions of this application. When the word "or" is used in reference to a list of two or more items, that word covers all of the following interpretations of the word: any of the items in the list, all of the items in the list and any combination of the items in the list.

In the description above and throughout, numerous specific details are set forth in order to provide a thorough understanding of the disclosure. It will be evident, however, to one of ordinary skill in the art, that the disclosure may be practiced without these specific details. In other instances, well-known structures and devices are shown in block diagram form to facilitate explanation. The description of the preferred embodiments is not intended to limit the scope of the claims appended hereto. Further, in the methods disclosed herein, various steps are disclosed illustrating some of the functions of the disclosure. One will appreciate that these steps are merely exemplary and are not meant to be limiting in any way. Other steps and functions may be contemplated without departing from this disclosure, the scope of the invention being defined in the claims.

Determining the frequency for the device may be performed in numerous different ways. In an embodiment, the predetermined frequency for the device may be determined by playing swept tones on the device within a predetermined frequency range at a plurality of different tone strengths, and recording levels of harmonic distortion of recordings made of the device for each played swept tone. A frequency may be identified within the predetermined frequency range wherein the recorded levels of harmonic distortion have a peak. Each of the notch filter and the peak filter may be tuned by setting the center frequency of each filter to the identified frequency. In another embodiment, the predetermined frequency for the device is set at a frequency wherein harmonic distortion is greatest on average for a plurality of devices.

A computer program product is described for dynamically suppressing non-linear distortion for a device.

In various embodiments the notch filter(s) is/are implemented in the time domain. In various embodiments the peak filter(s) is/are implemented in the time domain.

In various embodiments, combining two or more audio signals into a combined audio signal is performed by summing the two or more audio signals. The summing of the two or more audio signals may comprise calculating a weighted sum, for example.

**Claims**

1. A system for providing dynamic suppression of distortion in an audio signal, the system comprising:

   $N$ notch filters (515, 530) connected in series and configured to receive an input audio signal (510) and to output a notch-filtered audio signal, wherein N is an integer greater than or equal to 1;
   $N$ peak filters (520, 525) configured to receive the input audio signal (510) and to output N peak-filtered audio signals, wherein the, or each of the, $N$ peak filters has the same center frequency as the, or a respective one of the, N notch filters;
   means (250) for computing respective tone-strength values and signal-energy values for the notch-filtered audio signal and the N peak-filtered audio signals;
   a first limiter (550) configured to limit the notch-filtered audio signal according to a target output level set in dependence on the tone-strength and signal-energy values computed for the notch-filtered audio signal, thereby generating a first limited audio signal;
   $N$ further limiters (560, 570) configured to limit the $N$ peak-filtered audio signals according to respective target output levels set in dependence on the respective tone-strength and signal-energy values computed for the $N$ peak-filtered audio signals, thereby generating N further limited audio signals;
   means for combining the first and the N further limited audio signals, thereby generating a combined audio signal; and
   an output for outputting the combined audio signal.

2. A method of providing dynamic suppression of non-linear distortion in an audio signal, the method comprising:

   using N notch filters (515, 530) connected in series to receive (405) an input audio signal (510) and to output a notch-filtered audio signal, wherein N is an integer greater than or equal to 1;
   using N peak filters (520, 525) to receive the input audio signal (510) and to output N peak-filtered audio signals, wherein the, or each of the, $N$ peak filters has the same center frequency as the, or a respective one of the, N notch filters;
   computing (420) respective tone-strength values and signal-energy values for the notch-filtered audio signal and the $N$ peak-filtered audio signals;
   limiting (440, 450) the notch-filtered audio signal according to a target output level set in dependence on the tone-strength and signal-energy values computed for the notch-filtered audio signal, thereby generating a first limited audio signal;
   limiting (440, 450) the $N$ peak-filtered audio signals according to respective target output levels set in dependence on the respective tone-strength and signal-energy values computed for the N peak-filtered audio signals, thereby generating N further limited audio signals;
   combining (460) the first and the $N$ further limited audio signals, thereby generating a combined audio signal; and
   outputting the combined audio signal.

3. The system of claim 1, or the method of claim 2, wherein each of the N frequency components comprises a predetermined frequency component that is found to trigger non-linear distortion in a target device.

4. The system of claim 3, or the method of claim 3, wherein the N center frequencies comprises a 280 Hz center frequency and/or a 430 Hz center frequency.

5. The system of any one of claims 1 and 3-4 , further comprising:

an input for receiving an audio signal (310) and a volume gain (320), the audio signal having a loudness parameter, the volume gain corresponding to a desired gain level for the audio signal;

means for generating a dynamically-filtered audio signal by applying dynamic filters (380) to the received audio signal based on the loudness parameter and the volume gain, wherein the dynamic filters (380) attenuate a low-frequency band of the received audio signal (310) and a high-frequency band of the received audio signal (310) in response to an increase the loudness parameter and the dynamic filters (380) boost the low-frequency band and the high-frequency band in response to a decrease in the loudness parameter; and

an output (390) for supplying the dynamically-filtered audio signal, as the input audio signal, to the N notch filters and the N peak filters.

6. The method of any one of claims 2-4 , further comprising:

receiving an audio signal (310) and a volume gain (320), the audio signal having a loudness parameter, the volume gain corresponding to a desired gain level for the audio signal;

generating a dynamically-filtered audio signal by applying dynamic filters (380) to the received audio signal based on the loudness parameter and the volume gain, wherein the dynamic filters (380) attenuate a low-frequency band of the received audio signal (310) and a high-frequency band of the received audio signal (310) in response to an increase the loudness parameter and the dynamic filters (380) boost the low-frequency band and the high-frequency band in response to a decrease in the loudness parameter; and

supplying the dynamically-filtered audio signal, as the input audio signal, to the $N$ notch filters and the $N$ peak filters.

7. A computer program product comprising instructions which when executed by a computing device or system cause the computing device or system to perform the method of any one of claims 2-4 and 6.

8. A computer readable medium having stored thereon the computer program product according to claim 7.

**Patentansprüche**

1. System zum Bereitstellen von dynamischer Unterdrückung von Verzerrung in einem Audiosignal, wobei das System Folgendes umfasst:

$N$ Kerbfilter (515, 530), die in Serie verbunden und konfiguriert sind, um ein Audioeingabesignal (510) zu empfangen und ein kerbgefiltertes Audiosignal auszugeben, wobei $N$ eine ganze Zahl größer oder gleich 1 ist;

$N$ Spitzenfilter (520, 525), die konfiguriert sind, um das Audioeingabesignal (510) zu empfangen und $N$ spitzengefilterte Audiosignals auszugeben, wobei der oder jeder der $N$ Spitzenfilter die gleiche Mittenfrequenz wie der oder ein jeweiliger einer der $N$ Kerbfilter aufweist;

Mittel (250) zum Berechnen von entsprechenden Tonstärkewerten und Signalenergiewerten, für das kerbgefilterte Audiosignal und die $N$ spitzengefilterte Audiosignale;

einen ersten Begrenzer (550), der konfiguriert ist, um das kerbgefilterte Audiosignal zu begrenzen gemäß einem Zielausgabepegel, der abhängig von der Tonstärke und den Signalenergiewerten, die für das kerbgefilterte Audiosignal berechnet wurden, eingestellt wird, und dadurch Erzeugen eines ersten begrenzten Audiosignals;

$N$ weitere Begrenzer (560, 570), die konfiguriert sind, um die $N$ spitzengefilterten Audiosignale zu begrenzen gemäß jeweiligen Zielausgabepegeln, die abhängig von der jeweiligen Tonstärke und den jeweiligen Signalenergiewerten, die für die $N$ spitzengefilterten Audiosignale errechnet wurden, eingestellt werden, und dadurch Erzeugen von $N$ weiter begrenzten Audiosignalen;

Mittel zum Kombinieren des ersten und der $N$ weiter begrenzten Audiosignale und dadurch Erzeugen eines kombinierten Audiosignals; und eine Ausgabe zum Ausgeben des kombinierten Audiosignals.

2. Verfahren zum Bereitstellen von dynamischer Unterdrückung von nicht linearer Verzerrung in einem Audiosignal, wobei das Verfahren Folgendes umfasst:

Verwenden von $N$ Kerbfiltern (515, 530) die in Serie verbunden sind, um ein Audioeingabesignal (510) zu empfangen (405) und ein kerbgefiltertes Audiosignal auszugeben, wobei $N$ eine ganze Zahl größer oder gleich 1 ist;

Verwenden von $N$ Spitzenfiltern (520, 525), um das Audioeingabesignal (510) zu empfangen und $N$ spitzengefilterte Audiosignale auszugeben, wobei der oder jeder der N Spitzenfilter die gleiche Mittenfrequenz wie der oder ein jeweiliger einer der $N$ Kerbfilter aufweist;

Berechnen (420) von jeweiligen Tonstärkewerten und Signalenergiewerten für das kerbgefilterte Audiosignal und die $N$ spitzengefilterten Audiosignale;

Begrenzen (440, 450) des kerbgefilterten Audiosignals gemäß einem Zielausgabepegel, der abhängig von der Tonstärke und den Signalenergiewerten, die für das kerbgefilterte Audiosignal berechnet wurden, eingestellt wird, und dadurch Erzeugen eines ersten begrenzten Audiosignals;

Begrenzen (440, 450) der *N* spitzengefilterten Audiosignale gemäß jeweiligen Zielausgabepegeln, die abhängig von der jeweiligen Tonstärke und den jeweiligen Signalenergiewerten, die für die *N* spitzengefilterten Audiosignale errechnet wurden, eingestellt werden, und dadurch Erzeugen von *N* weiter begrenzten Audiosignalen;

Kombinieren (460) des ersten und der *N* weiter begrenzten Audiosignale und dadurch Erzeugen eines kombinierten Audiosignals; und

Ausgeben des kombinierten Audiosignals.

3. System nach Anspruch 1 oder Verfahren nach Anspruch 2, wobei jede der *N* Frequenzkomponenten eine vorbestimmte Frequenzkomponente umfasst, von der erkannt ist, dass in einer Zielvorrichtung sie nicht lineare Verzerrung auslöst.

4. System nach Anspruch 3 oder Verfahren nach Anspruch 3, wobei die *N* Mittenfrequenzen eine 280-Hz-Mittenfrequenz und/oder eine 430-Hz-Mittenfrequenz umfassen.

5. System nach einem der Ansprüche 1 und 3-4, weiter umfassend:

eine Eingabe zum Empfangen eines Audiosignals (310) und einer Laustärkezunahme (320), wobei das Audiosignal einen Lautheitsparameter aufweist, wobei die Laustärkezunahme einem gewünschten Zunahmepegel für das Audiosignal entspricht;

Mittel zum Erzeugen eines dynamisch gefilterten Audiosignals durch Anwenden von dynamischen Filtern (380) auf das empfangene Audiosignal auf der Grundlage des Lautheitsparameters und der Laustärkezunahme, wobei die dynamischen Filter (380) ein Niederfrequenzband des empfangenen Audiosignals (310) und ein Hochfrequenzband des empfangenen Audiosignal (310) als Antwort auf eine Erhöhung des Lautheitsparameters abschwächen, und die dynamischen Filter (380) das Niederfrequenzband und das Hochfrequenzband als Antwort auf ein Absenken im Lautheitsparameter verstärken; und

eine Ausgabe (390) zum Abgeben des dynamisch gefilterten Audiosignals als das Audioeingabesignal an die *N* Kerbfilter und die *N* Spitzenfilter.

6. Verfahren nach einem der Ansprüche 2-4, weiter umfassend:

Empfangen eines Audiosignals (310) und einer Laustärkezunahme (320), wobei das Audiosignal einen Lautheitsparameter aufweist, wobei die Laustärkezunahme einem gewünschten Zunahmepegel für das Audiosignal entspricht;

Erzeugen eines dynamisch gefilterten Audiosignals durch Anwenden von dynamischen Filtern (380) auf das empfangene Audiosignal auf der Grundlage des Lautheitsparameters und der Laustärkezunahme, wobei die dynamischen Filter (380) ein Niederfrequenzband des empfangenen Audiosignals (310) und ein Hochfrequenzband des empfangenen Audiosignal (310) als Antwort auf eine Erhöhung des Lautheitsparameters abschwächen, und die dynamischen Filter (380) das Niederfrequenzband und das Hochfrequenzband als Antwort auf ein Absenken im Lautheitsparameter verstärken; und

Abgeben des dynamisch gefilterten Audiosignals als das Audioeingabesignal an die *N* Kerbfilter und die *N* Spitzenfilter.

7. Computerprogrammprodukt, umfassend Anweisungen, die, wenn sie von einer Rechenvorrichtung oder System ausgeführt werden, verursachen, dass die Rechenvorrichtung oder das System das Verfahren nach einem der Ansprüche 2-4 und 6 durchführt.

8. Computerlesbares Medium, auf dem das Computerprogrammprodukt nach Anspruch 7 gespeichert ist.

**Revendications**

1. Système pour fournir une suppression dynamique de distorsion dans un signal audio, le système comprenant :

N filtres coupe-bande (515, 530) connectés en série et configurés pour recevoir un signal audio d'entrée (510) et pour délivrer un signal audio filtré avec coupure de bande, dans lequel N est un entier supérieur ou égal à 1 ;

N filtres de crête (520, 525) configurés pour recevoir le signal audio d'entrée (510) et pour délivrer N signaux audio à crête filtrée, dans lequel le, ou chacun des, N filtres de crête a la même fréquence centrale que les, ou un respectifs des, N filtres coupe-bande ;

des moyens (250) pour calculer des valeurs de puissance de tonalité et des valeurs d'énergie de signal respectives pour le signal audio filtré avec coupure de bande et les N signaux audio à crête filtrée ;

un premier limiteur (550) configuré pour limiter le signal audio filtré avec coupure de bande selon un niveau de délivrance cible réglé en fonction des valeurs de puissance de tonalité et d'énergie de signal calculées pour le signal audio à crête filtrée, générant ainsi un premier signal audio limité ;

N limiteurs supplémentaires (560, 570) configurés pour limiter les N signaux audio à crête filtrée selon des niveaux de délivrance cibles respectifs réglés en fonction des valeurs de puissance de tonalité et d'énergie de signal respectives calculées pour les N signaux audio à crête filtrée, générant ainsi N signaux audio limités supplémentaires ;

des moyens pour combiner les premiers et les N signaux audio limités supplémentaires, générant ainsi un signal audio combiné ; et

une sortie pour délivrer le signal audio combiné.

2. Procédé de fourniture de suppression dynamique d'une distorsion non linéaire dans un signal audio, le procédé comprenant :

l'utilisation de N filtres coupe-bande (515, 530) connectés en série pour recevoir (405) un signal audio d'entrée (510) et pour délivrer un signal audio filtré avec coupure de bande, dans lequel N est un entier supérieur ou égal à 1 ;

l'utilisation de *N* filtres de crête (520, 525) pour recevoir le signal audio entré (510) et pour délivrer N signaux audio à crête filtrée, dans lequel les, ou chacun des, *N* filtres de crête ont la même fréquence centrale que les, ou un respectif des, N filtres coupe-bande ;

le calcul (420) de valeurs de puissance de tonalité et de valeurs d'énergie de signal respectives pour le signal audio filtré avec coupure de bande et les N signaux audio à crête filtrée ;

la limitation (440, 450) du signal audio filtré avec coupure de bande selon un niveau de délivrance cible réglé en fonction des valeurs de puissance de tonalité et d'énergie de signal calculées pour le signal audio filtré avec coupure de bande, générant ainsi un premier signal audio limité ;

la limitation (440, 450) des N signaux audio à crête filtrée selon des niveaux de délivrance cibles respectifs réglés en fonction des valeurs de puissance de tonalité et d'énergie de signal respectives calculées pour les N signaux audio à crête filtrée, générant ainsi N signaux audio limités supplémentaires ;

la combinaison (460) des premiers et des N signaux audio limités supplémentaires, générant ainsi un signal audio combiné ; et

la délivrance du signal audio combiné.

3. Système selon la revendication 1, ou procédé selon la revendication 2, dans lequel chacune des N composantes de fréquence comprend une composante de fréquence prédéterminée qui s'avère déclencher une distorsion non linéaire dans un dispositif cible.

4. Système selon la revendication 3, ou procédé selon la revendication 3, dans lequel les *N* fréquences centrales comprennent une fréquence centrale de 280 Hz et/ou une fréquence centrale de 430 Hz.

5. Système selon l'une quelconque des revendications 1 et 3-4, comprenant en outre :

une entrée pour recevoir un signal audio (310) et un gain de volume (320), le signal audio ayant un paramètre de force sonore, le gain de volume correspondant à un niveau de gain souhaité pour le signal audio ;

des moyens pour générer un signal audio à filtrage dynamique en appliquant des filtres dynamiques (380) au signal audio reçu sur la base du paramètre de force sonore et du gain de volume, dans lequel les filtres dynamiques (380) atténuent une bande de basse fréquence du signal audio reçu (310) et une bande de haute fréquence du signal audio reçu (310) en réponse à une augmentation que le paramètre de force sonore et les filtres dynamiques (380) amplifient la bande de basse fréquence et la bande de haute fréquence en réponse à une diminution du paramètre de force sonore ; et

une sortie (390) pour fournir le signal audio à filtrage dynamique, en tant que signal audio d'entrée, aux N filtres coupe-bande et aux N filtres de crête.

6. Procédé selon l'une quelconque des revendications 2-4, comprenant en outre :

la réception d'un signal audio (310) et d'un gain de volume (320), le signal audio ayant un paramètre de force sonore, le gain de volume correspondant à un niveau de gain souhaité pour le signal audio ;

la génération d'un signal audio à filtrage dynamique en appliquant des filtres dynamiques (380) au signal audio reçu sur la base du paramètre de force sonore et du gain de volume, dans lequel les filtres dynamiques (380) atténuent une bande de basse fréquence du signal audio reçu (310) et une bande de haute fréquence du signal audio reçu (310) en réponse à une augmentation que le paramètre de force sonore et les filtres dynamiques (380) amplifient la bande de basse fréquence et la bande de haute fréquence en réponse à une diminution du paramètre de force sonore ; et

la fourniture du signal audio à filtrage dynamique, en tant que signal audio d'entrée, aux N filtres coupe-bande et aux N filtres de crête.

7.  Produit de programme informatique comprenant des instructions qui, lorsqu'elles sont exécutées par un dispositif ou système informatique, amènent le dispositif ou système informatique à réaliser le procédé selon l'une quelconque des revendications 2-4 et 6.

8.  Support lisible sur ordinateur ayant, stocké sur celui-ci, le produit de programme informatique selon la revendication 7.

100

```
                    ┌─────────────────────────────────────────────┐ ╭110
                    │   Receive Signal Having Non-linear Distortion │
                    └─────────────────────────────────────────────┘
                                        │
                                        ▼
      ┌──────────────────────────────────────────────────────┐ ╭120
      │   Analyze Signal to Identify Tone Strength and Band Level │
      └──────────────────────────────────────────────────────┘
                                        │
                                        ▼
    ┌──────────────────────────────────────────────────────────┐ ╭130
    │   Filter Signal by Reducing Suppression of Non-linear       │
    │   Distortion when Tone Strength is Low, and Increasing      │
    │   Suppression when Tone Strength is High                    │
    └──────────────────────────────────────────────────────────┘
```

## FIG. 1

200

```
           ╭210              ╭230                  ╭240        260╮
      Input Signal ───────▶ ┌──────────┐         ┌──────────┐   Output
                            │ Dynamic  │──────●──▶│ Multiband│──▶ Signal
           ╭220             │Shelf Filters│      │  Limiter │
      Volume Gain ─────────▶└──────────┘    │    └──────────┘
                                            │         ▲
                                            │         │    ╭250
                                            │    ┌──────────┐
                                            └───▶│Analysis and│
                                                 │Target Selection│
                                                 └──────────┘
```

## FIG. 2

FIG. 3

300

Input Signal /310    Gain at 1 kHz /320

330 — Delay

340 High Pass Filter

350 Compute Autocorrelation

360 Compute Target Gain Per Band

370 Compute LF and HF Filters Parameters

380 Apply Low Freq and High Freq Filters

Processed Signal /390

FIG. 4

400

Receive Signal by Multiband Limiter /405

Split Signal Using Notch Filter and Peak Filter into Multiple Bands /410

Determine Tone Strength and Band Level of Each Band of Split Signal /420

Set Limiter Target Output Level for Limiters /440

Limit Output of Each Filter by the Limiters /450

Combine Output of Limiters /460

15

**FIG. 5**

**FIG. 6**

**FIG. 7**

**Limiter Target (Including 3 dB Headroom) in dB**

**FIG. 8A**

**Amount of Suppression in dB**

**FIG. 8B**

*FIG. 9*

*1000*

325  155  100  145  305

280 Hz

105 Hz

280 Hz

985    325    100    330    960

Loudness = -15db

## FIG. 10A

*1050* Without Volume Modeler

325  155  100  145  305

425 Hz

420 Hz

260 Hz

420 Hz

280 Hz

985    325    100    330    960

Loudness = -9db

## FIG. 10B

FIG. 11A

FIG. 11B

**FIG. 12**

**REFERENCES CITED IN THE DESCRIPTION**

**Patent documents cited in the description**

- US 2013142360 A1
- EP 2600636 A1